(19) Europäisches Patentamt / European Patent Office / Office européen des brevets

(11) **EP 3 340 326 B1**

(12) **FASCICULE DE BREVET EUROPEEN**

(45) Date de publication et mention de la délivrance du brevet:
**19.06.2019 Bulletin 2019/25**

(51) Int Cl.:
***H01L 41/107*** *(2006.01)*  *H01L 41/193* *(2006.01)*
*H01L 41/083* *(2006.01)*

(21) Numéro de dépôt: **17206829.8**

(22) Date de dépôt: **12.12.2017**

(54) **TRANSFORMATEUR PIÉZOÉLECTRIQUE**

PIEZOELEKTRISCHER TRANSFORMATOR

PIEZOELECTRIC TRANSFORMER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2016 FR 1662767**

(43) Date de publication de la demande:
**27.06.2018 Bulletin 2018/26**

(73) Titulaire: **Commissariat à l'Energie Atomique et aux Energies Alternatives**
**75015 Paris (FR)**

(72) Inventeurs:
• **GWOZIECKI, Romain**
**38000 GRENOBLE (FR)**
• **GALLIARI, Marine**
**74650 CHAVANOD (FR)**
• **LATOUR, Antoine**
**38000 GRENOBLE (FR)**

(74) Mandataire: **Cabinet Beaumont**
**4, Place Robert Schuman**
**B.P. 1529**
**38025 Grenoble Cedex 1 (FR)**

(56) Documents cités:
**EP-A1- 0 915 524     JP-A- 2006 041 150**

• **VUCHEVA Y D ET AL: "Investigation of MEMS piezoelectric transformer with PVDF thin layer", MATERIALS SCIENCE FORUM, vol. 856, 19 mai 2016 (2016-05-19), pages 356-361, XP055326104, DOI: 10.4028/www.scientific.net/MSF.856.356**

**Description**

Domaine

La présente demande concerne un transformateur de tension piézoélectrique et plus particulièrement un transformateur de tension piézoélectrique pour tension ayant une fréquence comprise entre 1 Hz et 1000 Hz.

Exposé de l'art antérieur

Il est connu d'utiliser des matériaux piézoélectriques, tels que des céramiques piézoélectriques, pour réaliser des transformateurs de tension. Ces transformateurs de tension sont généralement adaptés à des tensions périodiques ayant une fréquence comprise entre 10 kHz et 150 kHz. Il existe plusieurs types de transformateurs de tension piézoélectriques comme des transformateurs multicouches, des transformateurs circulaires ou encore des transformateurs de Rosen.

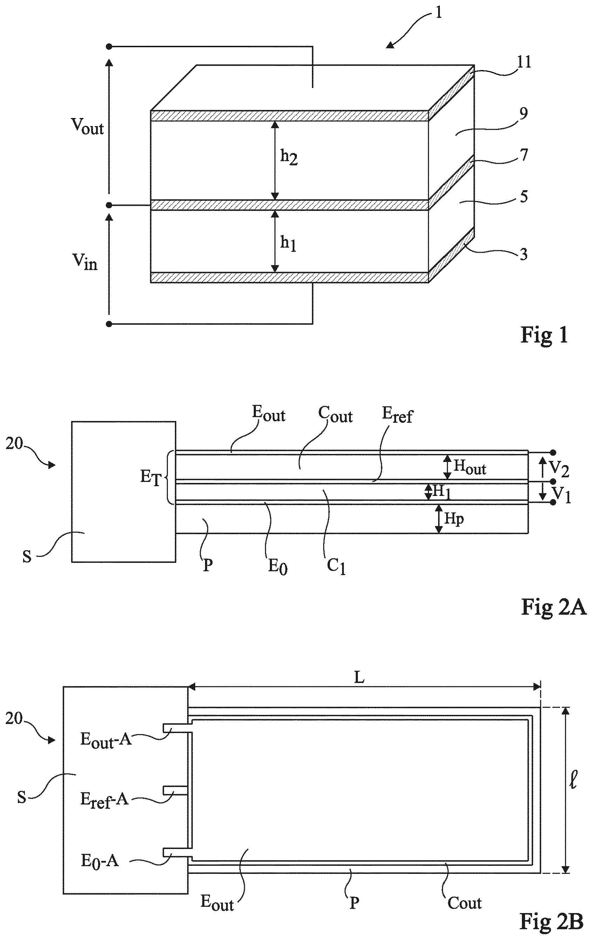

La figure 1 est une vue en perspective d'un exemple de transformateur de tension piézoélectrique 1. Le transformateur 1 est un transformateur de tension piézoélectrique de type multicouches. Le transformateur 1 comprend un empilement comprenant successivement du bas vers le haut en figure 1 :

- une électrode 3 ;
- une couche piézoélectrique 5 ayant une épaisseur $h_1$ ;
- une électrode 7 ;
- une couche piézoélectrique 9 ayant une épaisseur $h_2$ ; et
- une électrode 11.

Une tension périodique d'entrée $V_{in}$ est appliquée entre les électrodes 3 et 7. Les électrodes 3 et 7 étant en contact avec la couche 5, un effet piézoélectrique inverse est produit et la couche 5 de matériau piézoélectrique se déforme mécaniquement. Cette déformation mécanique est communiquée à tout l'empilement et plus particulièrement à la couche piézoélectrique 9. Par effet piézoélectrique direct, la couche 9 produit une tension de sortie $V_{out}$ mesurée entre les électrodes 11 et 7.

A titre d'exemple, lorsque les conditions suivantes sont réunies :

- les couches 5 et 9 ont des surfaces identiques ;
- les couches 5 et 9 sont en un même matériau ; et
- les épaisseurs des électrodes 3, 7 et 11 sont négligeables par rapport à celles des couches 5 et 9,

les tensions $V_{in}$ et $V_{out}$ sont liées entre elles par la relation (1) suivante :

$$\frac{V_{out}}{h2} = \frac{V_{in}}{h1} \qquad (1)$$

Le facteur d'amplification est donc le rapport entre l'épaisseur $h_2$ de la couche 9 et l'épaisseur $h_1$ de la couche 5. Les épaisseurs $h_1$ et $h_2$ sont donc choisies en fonction du facteur d'amplification souhaité.

Les couches piézoélectriques 5 et 9 sont généralement composées de céramiques piézoélectriques ayant un module d'Young supérieur à 70 GPa, par exemple de l'ordre de 100 GPa. Pour des épaisseurs de matériaux piézoélectriques comprises entre 1 mm et 10 mm, ce type de transformateur de tension peut traiter des tensions périodiques ayant des fréquences comprises entre 30 kHz et 100 kHz.

JP 2006-041150 A divulgue un transformateur de tension piézoélectrique comprenant une membrane et sur ladite membrane un empilement alternant des électrodes et des couches piézoélectriques en un matériau polymère (e.g. PVDF), ayant une fréquence de résonance d'au moins 130 kHz.

Vucheva Y D et al, Materials Science Forum, vol. 856, pages 356-361, 2016, propose un transformateur comportant une électrode inférieure, une couche de PVDF, et une électrode supérieure déposées sur une lame support en polymère.

EP 0 915 524 A1 décrit un transformateur comportant un empilement des électrodes et des couches piézoélectriques en un matériau céramique ou monocristal sur une poutre résonante en métal, adapté pour les fréquences basses (50 Hz).

Il serait utile de pouvoir concevoir un transformateur de tension du type multicouches adapté à des tensions périodiques ayant des fréquences comprises entre 1 Hz et 1000 Hz. Un transformateur de la sorte serait utile notamment pour des domaines dans lesquels sont utilisés des systèmes ou des microsystèmes basés sur des générateurs de type machine tournante comme des éoliennes ou des micro-turbines. Un inconvénient du transformateur de tension multicouches représenté en figure 1 est qu'il n'est pas adapté pour de telles fréquences.

<u>Résumé</u>

Un objet d'un mode de réalisation est de pallier tout ou partie des inconvénients des transformateurs piézoélectriques décrits précédemment.

Un autre objet d'un mode de réalisation est que le transformateur piézoélectrique soit adapté à être utilisé avec des tensions périodiques dont la fréquence est comprise entre 1 Hz et 1000 Hz.

Un autre objet d'un mode de réalisation est que le transformateur piézoélectrique comprenne des matériaux piézoélectriques autres que des céramiques piézoélectriques.

Ainsi, un mode de réalisation prévoit un transformateur de tension comprenant une poutre ou membrane en un premier matériau polymère ayant une fréquence de résonance comprise entre 1 Hz et 1000 Hz, et comprenant sur ladite poutre ou membrane un empilement comprenant successivement : une première électrode ; une première couche piézoélectrique en un deuxième matériau polymère ; une deuxième électrode ; une deuxième couche piézoélectrique en un troisième matériau polymère identique au deuxième matériau polymère ou différent du deuxième matériau polymère ; et une troisième électrode.

Selon un mode de réalisation, le premier matériau polymère a un module d'Young inférieur à 10 GPa.

Selon un mode de réalisation, le premier matériau polymère est du polyéthylène naphtalate ou du polyéthylène téréphtalate.

Selon un mode de réalisation, les deuxième et troisième matériaux polymère comprennent du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

Selon un mode de réalisation, le transformateur comprend en outre un support et la poutre ou membrane est fixée par l'une de ses extrémités au support.

Selon un mode de réalisation, le deuxième matériau polymère et le troisième matériau polymère sont identiques et l'épaisseur de la première couche est différente de l'épaisseur de la deuxième couche.

Selon un mode de réalisation, la poutre ou membrane a une longueur comprise entre 1 mm et 100 mm et une épaisseur comprise entre 50 $\mu$m et 200 $\mu$m, et les première et deuxième couches ont une épaisseur comprise entre 1 $\mu$m et 50 $\mu$m.

Selon un mode de réalisation, l'empilement comprend en outre successivement, entre la première couche piézoélectrique et la deuxième électrode, une quatrième électrode et une troisième couche piézoélectrique en un quatrième matériau polymère.

Selon un mode de réalisation, le quatrième matériau polymère comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

Selon un mode de réalisation, le transformateur comprend des moyens d'application d'une première tension entre la quatrième électrode et la première électrode et entre la quatrième électrode et la deuxième électrode et comprend des moyens de récupération d'une deuxième tension entre la troisième électrode et la deuxième électrode.

Selon un mode de réalisation, l'empilement comprend en outre successivement, entre la troisième couche et la deuxième électrode, une cinquième électrode et une quatrième couche piézoélectrique en un cinquième matériau polymère.

Selon un mode de réalisation, le cinquième matériau polymère comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

Selon un mode de réalisation, le transformateur comprend des moyens d'application d'une première tension entre : la première électrode et la quatrième électrode ; la cinquième électrode et la quatrième électrode ; et la cinquième électrode et la deuxième électrode, et comprend des moyens de récupération d'une deuxième tension entre la troisième électrode et la deuxième électrode.

Selon un mode de réalisation, le transformateur comprend en outre un élément à rigidité commandable en contact avec l'empilement ou en contact avec la poutre ou membrane.

Selon un mode de réalisation, l'élément à rigidité commandable comprend une cinquième couche piézoélectrique en un sixième matériau polymère.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, précédemment décrite, illustre un transformateur de tension piézoélectrique ;
les figures 2A et 2B illustrent un mode de réalisation d'un transformateur de tension piézoélectrique ;
les figures 3A à 3C illustrent des variantes de réalisation du transformateur de tension piézoélectrique représenté sur les figures 2A et 2B ; et
les figures 4 et 5 illustrent d'autres modes de réalisation d'un transformateur de tension piézoélectrique.

Description détaillée

De mêmes éléments ont été désignés par de mêmes références dans les différentes figures. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "haut", "bas", etc., ou relative, tels que les termes "dessus", "supérieur", "inférieur", il est fait référence à l'orientation des figures. Sauf précision contraire, les expressions "sensiblement", et "de l'ordre de" signifient à 10 % près, de préférence à 5 % près.

Dans la suite de la description, le module d'Young d'un matériau élastique linéaire est défini par la constante qui relie la contrainte de traction ou de compression et la déformation du matériau.

Dans la suite de la description, l'expression "élément à base de polyfluorure de vinylidène (PVDF)" signifie un copolymère comprenant au moins 70 % en masse molaire du monomère fluorure de vinylidène (VDF) et éventuellement au moins un autre monomère comme par exemple le trifluoroéthylène (TrFE) ou le tétrafluoroéthylène (TFE).

Les figures 2A et 2B sont respectivement une vue en coupe et une vue de dessus, partielles et schématiques, d'un mode de réalisation d'un transformateur de tension piézoélectrique 20 de type multicouches. Le transformateur de tension 20 est adapté à des tensions périodiques ayant une fréquence comprise entre 1 Hz et 1000 Hz, par exemple de l'ordre de 60 Hz.

Le transformateur 20 comprend une poutre ou membrane P en un matériau polymère et comprend, sur la poutre ou membrane P, un empilement $E_T$ de couches piézoélectriques et de couches d'électrodes. Dans la suite de la description, on parlera de poutre P pour désigner la poutre ou membrane P. Les dimensions et le matériau de la poutre P sont choisis pour que sa fréquence de résonance soit comprise entre 1 Hz et 1000 Hz, par exemple de l'ordre de 60 Hz. Le matériau composant la poutre P peut être un polymère de module d'Young inférieur à 10 GPa, par exemple de l'ordre de 3 GPa. Un tel matériau est par exemple du polyéthylène naphtalate (PEN), du polyéthylène téréphtalate (PET), un polyimide ou un polycarbonate. La poutre P peut être fixée à l'une de ses extrémités à un support S, par exemple par une liaison rigide, l'autre extrémité de la poutre P étant libre.

L'empilement $E_T$ comprend :

- une électrode $E_0$ reposant sur la poutre P, par exemple en contact avec la poutre P ;
- une couche piézoélectrique $C_1$ d'épaisseur $H_1$ en un matériau polymère reposant sur l'électrode $E_0$, par exemple en contact avec l'électrode $E_0$ ;
- une électrode $E_{ref}$ reposant sur la couche $C_1$, par exemple en contact avec la couche $C_1$ ;
- une couche piézoélectrique $C_{out}$ d'épaisseur $H_{out}$ en un matériau polymère, reposant sur l'électrode $E_{ref}$, par exemple en contact avec l'électrode $E_{ref}$ ; et
- une électrode $E_{out}$ reposant sur la couche $C_{out}$, par exemple en contact avec la couche $C_{out}$.

L'empilement $E_T$ de couches piézoélectriques et d'électrodes est similaire au transformateur de tension piézoélectrique décrit précédemment en relation avec la figure 1, à la différence que les couches piézoélectriques sont en un matériau polymère piézoélectrique.

Les couches piézoélectriques $C_1$ et $C_{out}$ peuvent être en un même matériau ou en des matériaux différents. Les couches piézoélectriques $C_1$ et $C_{out}$ sont chacune en un matériau polymère piézoélectrique, par exemple un composé à base de PVDF. Le composé à base de PVDF peut comprendre le seul polymère PVDF, un seul copolymère du PVDF, un mélange de deux ou plus de deux copolymères du PVDF, ou un mélange du polymère PVDF et d'au moins un copolymère du PVDF. De préférence, le copolymère du PVDF est le poly(fluorure de vinylidène - tri fluoro éthylène) (P(VDF-TrFE)), notamment le $P(VDF_x\text{-}TrFE_{100\text{-}x})$ où x est un nombre réel compris entre 60 et 80, notamment environ 70, le poly(fluorure de vinylidène), le poly(fluorure de vinylidène - trifluoroéthylène - chlorofluoroéthylène) (P(VDF-TrFE-CFE)) ou le poly(fluorure de vinylidène - trifluoroéthylène - chlorotrifluoro éthylène) (P(VDF-TrFE-CTFE)) .

Chaque électrode $E_0$, $E_{ref}$ et $E_{out}$ est en un matériau conducteur électriquement. Selon un mode de réalisation, chaque électrode est en un métal choisi parmi le groupe comportant l'or, le cuivre, l'argent, le titane et les alliages métalliques comprenant au moins l'un de ces métaux. Selon un mode de réalisation, chaque électrode $E_0$, $E_{ref}$, et $E_{out}$ est en un polymère électriquement conducteur, par exemple en poly(3,4-éthylènedioxythiophène) : poly(styrène sulfonate), couramment désigné par le sigle PEDOT : PSS. Selon un autre mode de réalisation, chaque électrode est une couche conductrice basée sur un composite de particules conductrices (particules d'argent, nanofils d'argent, nanotubes de carbone) et d'un matériau matrice comme un polymère, garant de la flexibilité de l'électrode.

La poutre P et les couches $C_1$ et $C_{out}$ sont, en vue de dessus, d'aires sensiblement égales. Selon un mode de réalisation, les électrodes $E_0$, $E_{ref}$ et $E_{out}$ sont de forme rectangulaire.

On a représenté en figure 2B de façon très schématique des plots de contact $E_0$-A, $E_{ref}$-A et $E_{out}$-A respectivement pour les électrodes $E_0$, $E_{ref}$ et $E_{out}$. Ces plots de contact sont par exemple des allongements $E_0$-A, $E_{ref}$-A et $E_{out}$-A positionnés du côté du support S. Les allongements $E_0$-A, $E_{ref}$-A et $E_{out}$-A peuvent permettre de relier les électrodes à un circuit de commande non représenté.

La poutre P et l'empilement $E_T$ peuvent avoir une longueur L supérieure à 10 mm, par exemple comprise entre 10 mm et 100 mm, par exemple de l'ordre de 50 mm. La poutre P et l'empilement $E_T$ peuvent avoir une largeur $l$ comprise entre 100 $\mu$m et 10 mm, par exemple de l'ordre de 1 mm. La poutre P a une épaisseur Hp comprise entre 50 $\mu$m et 1 mm, par exemple de l'ordre de 100 $\mu$m. La couche $C_1$ a son épaisseur $H_1$ comprise entre 500 nm et 10 $\mu$m, par exemple de l'ordre de 2 $\mu$m. La couche $C_{out}$ a son épaisseur $H_{out}$ comprise entre 1 $\mu$m et 100 $\mu$m, par exemple de l'ordre de 10 $\mu$m. Les électrodes $E_0$, $E_{ref}$ et $E_{out}$ peuvent avoir une épaisseur comprise entre 100 nm et 10 $\mu$m, par exemple de l'ordre de 500 nm.

Le fonctionnement du transformateur de tension piézoélectrique 20 va maintenant être décrit. Une tension périodique $V_1$ est appliquée entre l'électrode $E_0$ et l'électrode $E_{ref}$. Par effet piézoélectrique inverse, la couche piézoélectrique $C_1$ vibre mécaniquement. Cette vibration mécanique est communiquée à l'empilement $E_T$ et à la poutre P. Ainsi la couche $C_{out}$ piézoélectrique vibre et produit une tension périodique $V_2$, entre les électrodes $E_{out}$ et $E_{ref}$, par effet piézoélectrique direct. A titre d'exemple, on peut relier l'électrode $E_{ref}$ à une source d'un potentiel de référence, par exemple la masse, non représentée sur les figures. Selon un mode de réalisation, on peut relier l'électrode $E_0$ à une source d'un potentiel d'entrée $V_{dd}$. La valeur du potentiel $V_{dd}$ est choisie pour obtenir avec le potentiel de référence la tension $V_1$, entre les électrodes $E_0$ et $E_{ref}$. D'après la relation (1) décrite précédemment, les tensions $V_1$ et $V_2$ sont liées entre elles par la relation (2) suivante :

$$\frac{V_1}{H_1} = \frac{V_2}{H_{out}} \qquad\qquad (2)$$

Le facteur d'amplification du transformateur est donc le rapport entre l'épaisseur $H_{out}$ de la couche $C_{out}$ et l'épaisseur $H_1$ de la couche $C_1$. Les épaisseurs $H_1$ et $H_{out}$ sont donc choisies en fonction du facteur d'amplification souhaité.

Selon un mode de réalisation, la fréquence de résonance de la poutre P est sensiblement égale à la fréquence de la tension périodique $V_1$, de façon à minimiser les pertes mécaniques. La poutre P peut avoir en outre un effet de tenue mécanique du transformateur 20.

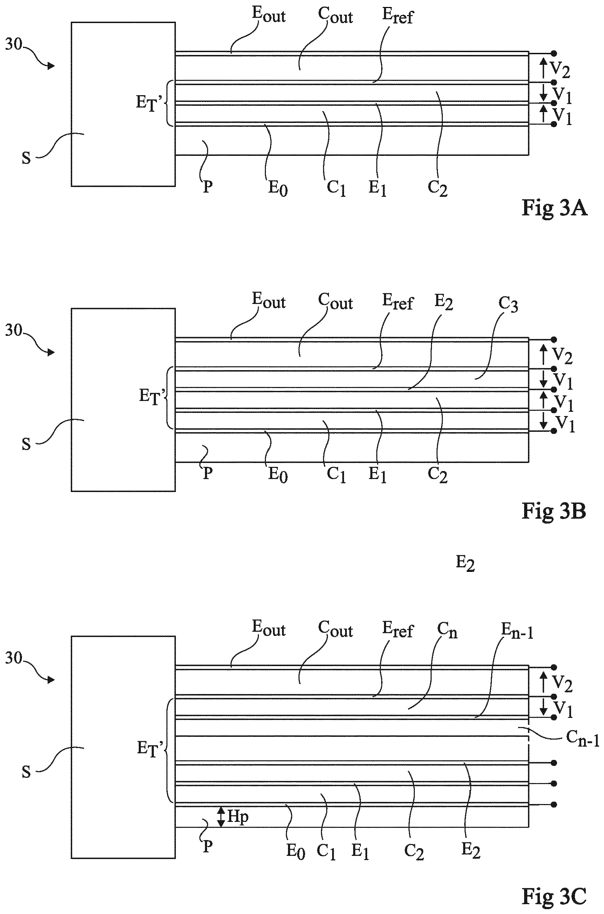

Les figures 3A à 3C sont des vues en coupe de modes de réalisation de transformateurs 30 de tension piézoélectriques. Ces transformateurs de tension piézoélectriques sont du même type que celui décrit en relation avec les figures 2A et 2B, à la différence que la couche piézoélectrique $C_1$ est comprise dans un empilement $E_T$' de couches piézoélectriques et d'électrodes.

Les couches piézoélectriques de l'empilement $E_T$' sont par exemple de même épaisseur ou d'épaisseurs différentes. Les couches piézoélectriques de l'empilement $E_T$' sont en des matériaux polymère piézoélectriques. Les couches piézoélectriques de l'empilement $E_T$' sont de préférence en un même matériau. En revanche, la couche $C_{out}$ peut être en un matériau différent de celui des couches piézoélectriques de l'empilement $E_T$'.

Les couches piézoélectriques de l'empilement $E_T$' sont chacune par exemple en un composé à base de PVDF. Le composé à base de PVDF peut comprendre le seul polymère PVDF, un seul copolymère du PVDF, un mélange de deux ou plus de deux copolymères du PVDF, ou un mélange du polymère PVDF et d'au moins un copolymère du PVDF. De préférence, le copolymère du PVDF est le poly(fluorure de vinylidène - tri fluoro éthylène) (P(VDF-TrFE)), notamment le P(VDF$_x$-TrFE$_{100-x}$) où x est un nombre réel compris entre 60 et 80, notamment environ 70, le poly(fluorure de vinylidène -), le poly(fluorure de vinylidène - trifluoroéthylène - chlorofluoroéthylène) (P(VDF-TrFE-CFE)) ou le poly(fluorure de vinylidène - trifluoroéthylène - chlorotrifluoro éthylène) (P(VDF-TrFE-CTFE)) .

Les électrodes de l'empilement $E_T$' sont en un matériau conducteur électriquement. Selon un mode de réalisation, les électrodes de l'empilement $E_T$' sont en un métal choisi parmi le groupe comportant l'or, le cuivre, l'argent, le titane et les alliages métalliques comprenant au moins l'un de ces métaux. Selon un mode de réalisation, chaque électrode de l'empilement $E_T$' est en un polymère électriquement conducteur, par exemple en poly(3,4-éthylènedioxythiophène) : poly(styrène sulfonate), couramment désigné par le sigle PEDOT : PSS. Selon un autre mode de réalisation, chaque électrode est une couche conductrice basée sur un composite de particules conductrices (particules d'argent, nanofils d'argent, nanotubes de carbone) et d'un matériau matrice comme un polymère, garant de la flexibilité de l'électrode.

La figure 3A illustre le cas où l'empilement $E_T'$ comprend deux couches piézoélectriques $C_1$ et $C_2$ séparées par une électrode $E_1$. Plus particulièrement, l'empilement $E_T'$ comprend successivement :

- la couche piézoélectrique $C_1$ reposant sur l'électrode $E_0$, par exemple en contact avec l'électrode $E_0$ ;
- l'électrode $E_1$ reposant sur la couche piézoélectrique $C_1$, par exemple en contact avec la couche $C_1$ ; et
- la couche piézoélectrique $C_2$ reposant sur l'électrode $E_1$, par exemple en contact avec l'électrode $E_1$.

L'électrode $E_{ref}$ repose alors sur la couche $C_2$, en étant par exemple en contact avec la couche $C_2$.

De la même façon qu'avec le transformateur 1 décrit précédemment en relation avec les figures 2A et 2B, les couches $C_1$ et $C_2$ sont excitées par la tension $V_1$. La tension $V_2$ est ensuite générée entre les électrodes $E_{ref}$ et $E_{out}$ par la couche $C_{out}$, par effet piézoélectrique direct. Selon un mode de réalisation, l'électrode $E_{ref}$ est reliée à la source du potentiel de référence. Dans ce cas, l'électrode $E_0$ est en outre reliée à la source du potentiel de référence. L'électrode $E_1$ est, quant à elle, reliée à la source du potentiel $V_{dd}$.

La figure 3B illustre le cas où l'empilement $E_T'$ comprend trois couches piézoélectriques $C_1$, $C_2$ et $C_3$ séparées par deux électrodes $E_1$ et $E_2$. Plus particulièrement, l'empilement $E_T'$ comprend successivement :

- la couche piézoélectrique $C_1$ reposant sur l'électrode $E_0$, par exemple en contact avec l'électrode $E_0$ ;
- l'électrode $E_1$ reposant sur la couche piézoélectrique $C_1$, par exemple en contact avec la couche $C_1$ ;
- la couche piézoélectrique $C_2$ reposant sur l'électrode $E_1$, par exemple en contact avec l'électrode $E_1$ ;
- l'électrode $E_2$ reposant sur la couche piézoélectrique $C_2$, par exemple en contact avec la couche $C_2$ ; et
- la couche piézoélectrique $C_3$ reposant sur l'électrode $E_2$, par exemple en contact avec l'électrode $E_2$.

L'électrode $E_{ref}$ repose sur la couche $C_3$, en étant par exemple en contact avec la couche $C_3$.

De la même façon qu'avec le transformateur 1 décrit précédemment en relation avec les figures 2A et 2B, les couches $C_1$ et $C_2$ sont excitées par la tension $V_1$. La tension $V_2$ est ensuite générée entre les électrodes $E_{ref}$ et $E_{out}$ par la couche $C_{out}$. Selon un mode de réalisation, l'électrode $E_{ref}$ est reliée à la source du potentiel de référence. Dans ce cas, les électrodes $E_0$ et $E_2$ sont reliées à la source du potentiel $V_{dd}$. L'électrode $E_1$ est, quant à elle, reliée à la source du potentiel de référence.

La figure 3C illustre le cas où l'empilement $E_T'$ comprend n couches piézoélectriques $C_1$, $C_2$, ..., $C_n$ séparées par n-1 électrodes $E_1$, ..., $E_{n-1}$, n étant un nombre entier, par exemple compris entre 2 et 20 tel que la somme des épaisseurs des couches $C_1$, $C_2$, ..., $C_n$ et des épaisseurs des électrodes $E_1$, ..., $E_{n-1}$ soit inférieure à l'épaisseur Hp de la poutre. La première couche $C_1$ repose sur l'électrode $E_0$, en étant par exemple en contact avec l'électrode $E_0$. La première électrode $E_1$ repose sur la couche $C_1$, en étant par exemple en contact avec la couche $C_1$. Ainsi, chaque couche $C_i$, i étant un entier variant de 2 à n, repose respectivement sur l'électrode $E_{i-1}$, par exemple en étant en contact avec l'électrode $E_{i-1}$. Et chaque électrode $E_{i-1}$ repose respectivement sur la couche $C_{i-1}$, par exemple en étant en contact de la couche $C_{i-1}$. L'électrode $E_{ref}$ repose sur la dernière couche $C_n$ de l'empilement $E_T'$, par exemple en étant en contact avec la couche $C_n$.

De la même façon qu'avec le transformateur 20 décrit précédemment en relation avec les figures 2A et 2B, les couches $C_1$, $C_2$, ..., $C_n$ sont excitées par la tension $V_1$. La tension $V_2$ est ensuite générée entre les électrodes $E_{ref}$ et $E_{out}$ par la couche $C_{out}$. Selon un mode de réalisation, l'électrode $E_{ref}$ est reliée à la source du potentiel de référence. Les électrodes $E_0$, $E_1$, ..., $E_{n-1}$ sont chacune reliée à la source du potentiel de référence ou à la source de potentiel $V_{dd}$. Pour appliquer une tension $V_1$ à chaque couche piézoélectrique $C_1$, $C_2$, ..., $C_n$, deux types de branchement des électrodes $E_1$, $E_2$, ..., $E_{n-1}$ sont possibles.

- Lorsque l'empilement $E_T'$ comprend un nombre n pair de couches piézoélectriques, les électrodes $E_1$, $E_3$,..., $E_{n-1}$ sont reliées à la source de potentiel $V_{dd}$ et les électrodes $E_0$, $E_2$,... $E_{n-2}$ sont reliées à la source de potentiel de référence.
- Lorsque l'empilement $E_T'$ comprend un nombre n impair de couches piézoélectriques, les électrodes $E_1$, $E_3$,..., $E_{n-2}$ sont reliées à la source de potentiel de référence et les électrodes $E_0$, $E_2$, ..., $E_{n-1}$ sont reliées à la source de potentiel $V_{dd}$.

Un avantage de ce mode de réalisation est de permettre au transformateur de tension piézoélectrique de fournir une plus grande puissance de sortie. En effet, en appliquant n fois la tension $V_1$, on multiplie par n la puissance d'entrée et ainsi la puissance de sortie.

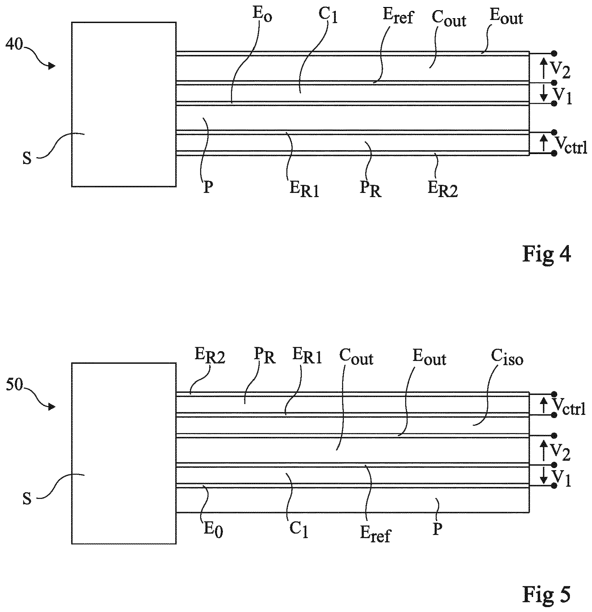

La figure 4 est une vue en coupe d'un mode de réalisation d'un transformateur de tension piézoélectrique 40. Le transformateur 40 est du même type que le transformateur 20 décrit en relation avec les figures 2A et 2B. Cependant, le transformateur 40 comprend en plus de la poutre P une poutre $P_R$ à raideur variable. La face supérieure de la poutre $P_R$ est en contact avec une électrode $E_{R1}$ et la face inférieure de la poutre $P_R$, opposée à la face supérieure, est en contact avec une électrode $E_{R2}$. De plus, si l'empilement $E_T$ est en contact avec la face supérieure de la poutre P, la face libre de l'électrode $E_{R1}$ est en contact avec la face inférieure, opposée à la face supérieure, de la poutre P. La poutre $P_R$ peut être en un matériau polymère piézoélectrique. La raideur de la poutre $P_R$ est contrôlée par effet piézoélectrique direct. La poutre $P_R$ est par exemple en un composé à base de PVDF. Le composé à base de PVDF peut comprendre le seul polymère PVDF, un seul copolymère du PVDF, un mélange de deux ou plus de deux copolymères du PVDF, ou un mélange du polymère PVDF et d'au moins un copolymère du PVDF. De préférence, le copolymère du PVDF est le poly(fluorure de vinylidène - tri fluoro éthylène) (P(VDF-TrFE)), notamment le $P(VDF_x-TrFE_{100-x})$ où x est un nombre réel compris entre 60 et 80, notamment environ 70, le poly(fluorure de vinylidène), le poly(fluorure de vinylidène - trifluoroéthylène - chlorofluoroéthylène) (P(VDF-TrFE-CFE)) ou le poly(fluorure de vinylidène - trifluoroéthylène - chlorotrifluoro éthylène) (P(VDF-TrFE-CTFE)). La poutre $P_R$ a une longueur par exemple comprise entre 10 mm et 100 mm, par exemple de l'ordre de 50 mm. La poutre $P_R$ a une largeur par exemple comprise entre 100 $\mu$m et 10 mm, par exemple de l'ordre de 1 mm. La poutre $P_R$ a une épaisseur par exemple comprise entre 500 nm et 10 $\mu$m, par exemple de l'ordre de 2 $\mu$m.

Les électrodes $E_{R1}$ et $E_{R2}$ sont en un matériau conducteur électriquement. Selon un mode de réalisation, les électrodes $E_{R1}$ et $E_{R2}$ sont en un métal choisi parmi le groupe comportant l'or, le cuivre, l'argent, le titane et les alliages métalliques comprenant au moins l'un de ces métaux. Selon un mode de réalisation, chaque électrode $E_{R1}$ et $E_{R2}$ est en un polymère électriquement conducteur, par exemple en poly(3,4-éthylènedioxythiophène) : poly(styrène sulfonate), couramment désigné par le sigle PEDOT : PSS. Selon un autre mode de réalisation, chaque électrode est une couche conductrice basée sur un composite de particules conductrices (particules d'argent, nanofils d'argent, nanotubes de carbone, ...) et d'un matériau matrice comme un polymère, garant de la flexibilité de l'électrode.

Le fonctionnement de ce mode de réalisation va maintenant être décrit. En appliquant une tension $V_{ctrl}$ continue entre les électrodes $E_{R1}$ et $E_{R2}$, des contraintes mécaniques s'établissent par effet piézoélectrique dans la poutre $P_R$. Ceci entraine une modification de la fréquence de résonance de la poutre P. La fréquence de résonance de la poutre P peut donc être commandée en fonction de la tension $V_{ctrl}$. Modifier la fréquence de résonance de la poutre P peut permettre d'ajuster la fréquence de résonance du transformateur, par exemple pour compenser des variations parasites. Ces variations parasites peuvent être dues à la dispersion des procédés ou à certaines conditions environnementales telles que la température.

La figure 5 est une vue en coupe d'un mode de réalisation d'un transformateur de tension piézoélectrique 50. Le transformateur 50 est du même type que le transformateur 40 décrit en relation avec la figure 4. Cependant, le transformateur 50 comprend en outre une couche isolante électriquement $C_{iso}$, dont la face supérieure repose sur et par exemple en contact avec la face supérieure de l'électrode de sortie $E_{out}$. La poutre $P_R$ à raideur variable et les électrodes $E_{R1}$ et $E_{R2}$ peuvent être positionnées sur et en contact avec la couche isolante $C_{iso}$. Le fonctionnement du transformateur 50 est le même que celui du transformateur 40 décrit en relation avec la figure 4.

Des modes de réalisation particuliers ont été décrits. Diverses variantes et modifications apparaîtront à l'homme de l'art. En particulier, la poutre $P_R$ et les électrodes $E_{R1}$ et $E_{R2}$ peuvent être disposées par exemple entre la poutre P et une couche isolante $C_{iso}$ sur laquelle reposerait l'empilement $E_T$.

Divers modes de réalisation avec diverses variantes ont été décrits ci-dessus. On notera que l'homme de l'art pourra combiner divers éléments de ces divers modes de réalisation et variantes sans faire preuve d'activité inventive. En particulier, les modes de réalisation décrits précédemment avec les figures 4 et 5 sont compatibles avec les modes de réalisation décrits précédemment avec les figures 3A à 3C.

## Revendications

1. Transformateur de tension comprenant une poutre ou membrane (P) en un premier matériau polymère ayant une fréquence de résonance comprise entre 1 Hz et 1000 Hz, et comprenant sur ladite poutre ou membrane (P) un empilement ($E_T$) comprenant successivement :

   une première électrode ($E_0$) ;
   une première couche ($C_1$) piézoélectrique en un deuxième matériau polymère ;
   une deuxième électrode ($E_{ref}$) ;
   une deuxième couche ($C_{out}$) piézoélectrique en un troisième matériau polymère identique au deuxième matériau polymère ou différent du deuxième matériau polymère ; et
   une troisième électrode ($E_{out}$).

**2.** Transformateur selon la revendication 1, dans lequel le premier matériau polymère a un module d'Young inférieur à 10 GPa.

**3.** Transformateur selon la revendication 1 ou 2, dans lequel le premier matériau polymère est du polyéthylène naphtalate (PEN) ou du polyéthylène téréphtalate (PET).

**4.** Transformateur selon l'une quelconque des revendications 1 à 3, dans lequel les deuxième et troisième matériaux polymère comprennent du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

**5.** Transformateur selon l'une quelconque des revendications 1 à 4, comprenant en outre un support (S) et dans lequel la poutre ou membrane (P) est fixée par l'une de ses extrémités au support (S).

**6.** Transformateur selon l'une quelconque des revendications 1 à 5, dans lequel le deuxième matériau polymère et le troisième matériau polymère sont identiques et l'épaisseur de la première couche ($C_1$) est différente de l'épaisseur de la deuxième couche ($C_{out}$).

**7.** Transformateur selon l'une quelconque des revendications 1 à 6, dans lequel la poutre ou membrane (P) a une longueur comprise entre 1 mm et 100 mm et une épaisseur comprise entre 50 $\mu$m et 200 $\mu$m, et dans lequel les première et deuxième couches ($C_1$, $C_{out}$) ont une épaisseur comprise entre 1 $\mu$m et 50 $\mu$m.

**8.** Transformateur selon l'une quelconque des revendications 1 à 7, dans lequel l'empilement ($E_T$) comprend en outre successivement, entre la première couche ($C_1$) piézoélectrique et la deuxième électrode ($E_{ref}$), une quatrième électrode ($E_1$) et une troisième couche ($C_2$) piézoélectrique en un quatrième matériau polymère.

**9.** Transformateur selon la revendication 8, dans lequel le quatrième matériau polymère comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

**10.** Transformateur selon la revendication 8 ou 9, comprenant des moyens d'application d'une première tension ($V_1$) entre la quatrième électrode ($E_1$) et la première électrode ($E_0$) et entre la quatrième électrode ($E_1$) et la deuxième électrode ($E_{ref}$) et comprenant des moyens de récupération d'une deuxième tension ($V_2$) entre la troisième électrode ($E_{out}$) et la deuxième électrode ($E_{ref}$).

**11.** Transformateur selon la revendication 8 ou 9, dans lequel l'empilement ($E_T$) comprend en outre successivement, entre la troisième couche ($C_2$) et la deuxième électrode ($E_{ref}$), une cinquième électrode ($E_2$) et une quatrième couche ($C_3$) piézoélectrique en un cinquième matériau polymère.

**12.** Transformateur selon la revendication 11, dans lequel le cinquième matériau polymère comprend du polyfluorure de vinylidène et/ou au moins un copolymère du polyfluorure de vinylidène, notamment un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

**13.** Transformateur selon la revendication 11 ou 12, comprenant des moyens d'application d'une première tension ($V_1$) entre :

la première électrode ($E_0$) et la quatrième électrode ($E_1$) ;
la cinquième électrode ($E_2$) et la quatrième électrode ($E_1$) ; et
la cinquième électrode ($E_2$) et la deuxième électrode ($E_{ref}$), et
comprenant des moyens de récupération d'une deuxième tension ($V_2$) entre la troisième électrode ($E_{out}$) et la deuxième électrode ($E_{ref}$).

**14.** Transformateur selon l'une quelconque des revendications 1 à 13, comprenant en outre un élément à rigidité commandable ($P_R$) en contact avec l'empilement ($E_T$) ou en contact avec la poutre ou membrane (P).

**15.** Transformateur selon la revendication 14, dans lequel l'élément à rigidité commandable comprend une cinquième couche ($P_R$) piézoélectrique en un sixième matériau polymère.

**Patentansprüche**

**1.** Spannungstransformator- bzw. -wandler, der einen Balken oder eine Membran (P) aus einem ersten Polymermaterial mit einer Resonanzfrequenz im Bereich von 1 Hz bis 1.000 Hz aufweist und auf dem Balken oder der Membran (P) einen Stapel ($E_T$) aufweist, der nacheinander Folgendes aufweist:

eine erste Elektrode ($E_0$);
eine erste piezoelektrische Schicht ($C_1$), die aus einem zweiten Polymermaterial hergestellt ist;
eine zweite Elektrode ($E_{ref}$);
eine zweite piezoelektrische Schicht ($C_{out}$) aus einem dritten Polymermaterial, das mit dem zweiten Polymermaterial identisch oder von dem zweiten Polymermaterial verschieden ist; und
eine dritte Elektrode ($E_{out}$).

**2.** Transformator nach Anspruch 1, wobei das erste Polymermaterial ein Young-Modul kleiner als 10 GPa aufweist.

**3.** Transformator nach Anspruch 1 oder 2, wobei das erste Polymermaterial Polyethylennaphthalat (PEN) oder Polyethylenterephthalat (PET) ist.

**4.** Transformator nach einem der Ansprüche 1 bis 3, wobei das zweite und dritte Polymermaterial Polyvinylidenfluorid und/oder wenigstens ein Copolymer von Polyvinylidenfluorid, insbesondere ein Polymer, ausgewählt aus der Gruppe bestehend aus Polyvinylidenfluorid, Poly(vinylidenfluorid-Trifluorethylen), Poly(vinylidenfluorid-Tetrafluorethylen) und einer Mischung aus wenigstens zwei dieser Polymere, aufweist.

**5.** Transformator nach einem der Ansprüche 1 bis 4, der ferner einen Träger (S) aufweist und wobei der Balken oder die Membran (P) mit einem seiner/ihrer Enden an dem Träger (S) befestigt ist.

**6.** Transformator nach einem der Ansprüche 1 bis 5, wobei das zweite Polymermaterial und das dritte Polymermaterial identisch sind und die Dicke der ersten Schicht ($C_1$) von der Dicke der zweiten Schicht ($C_{out}$) verschieden ist.

**7.** Transformator nach einem der Ansprüche 1 bis 6, wobei der Balken oder die Membran (P) eine Länge im Bereich von 1 mm bis 100 mm und eine Dicke im Bereich von 50 $\mu$m bis 200 $\mu$m aufweist, und wobei die ersten und zweiten Schichten ($C_1$, $C_{out}$) eine Dicke im Bereich von 1 $\mu$m bis 50 $\mu$m aufweisen.

**8.** Transformator nach einem der Ansprüche 1 bis 7, wobei der Stapel ($E_T$) ferner nacheinander zwischen der ersten piezoelektrischen Schicht ($C_1$) und der zweiten Elektrode ($E_{ref}$) eine vierte Elektrode ($E_1$) und eine dritte piezoelektrische Schicht ($C_2$) aus einem vierten Polymermaterial aufweist.

**9.** Transformator nach Anspruch 8, wobei das vierte Polymermaterial Polyvinylidenfluorid und/oder wenigstens ein Copolymer von Polyvinylidenfluorid, insbesondere ein Polymer, ausgewählt aus der Gruppe bestehend aus Polyvinylidenfluorid, Poly(vinylidenfluorid-Trifluorethylen), Poly(vinylidenfluorid-Tetrafluorethylen) und einer Mischung aus wenigstens zwei dieser Polymere, aufweist.

**10.** Transformator nach Anspruch 8 oder 9, der Mittel zum Anlegen einer ersten Spannung ($V_1$) zwischen der vierten Elektrode ($E_1$) und der ersten Elektrode ($E_0$) und zwischen der vierten Elektrode ($E_1$) und der zweiten Elektrode ($E_{ref}$) aufweist und Mittel zum Wiederherstellen einer zweiten Spannung ($V_2$) zwischen der dritten Elektrode ($E_{out}$) und der zweiten Elektrode ($E_{ref}$) aufweist.

**11.** Transformator nach Anspruch 8 und 9, wobei der Stapel ($E_T$) ferner nacheinander zwischen der dritten Schicht ($C_2$) und der zweiten Elektrode ($E_{ref}$) eine fünfte Elektrode ($E_2$) und eine vierte piezoelektrische Schicht ($C_3$) aus einem fünften Polymermaterial aufweist.

**12.** Transformator nach Anspruch 11, wobei das fünfte Polymermaterial Polyvinylidenfluorid und/oder wenigstens ein Copolymer von Polyvinylidenfluorid, insbesondere ein Polymer, ausgewählt aus der Gruppe bestehend aus Polyvinylidenfluorid, Poly(vinylidenfluorid-Trifluorethylen), Poly(vinylidenfluorid-Tetrafluorethylen) und einer Mischung aus wenigstens zwei dieser Polymere, aufweist.

**13.** Transformator nach Anspruch 11 oder 12, der Mittel zum Anlegen einer ersten Spannung ($V_1$) aufweist zwischen:

> der ersten Elektrode ($E_0$) und der vierten Elektrode ($E_1$);
> der fünften Elektrode ($E_2$) und der vierten Elektrode ($E_1$); und
> der fünften Elektrode ($E_2$) und der zweiten Elektrode ($E_{ref}$), und
> Mittel zur Wiederherstellung einer zweiten Spannung ($V_2$) zwischen der dritten Elektrode ($E_{out}$) und der zweiten Elektrode ($E_{ref}$) aufweist.

**14.** Transformator nach einem der Ansprüche 1 bis 13, der ferner ein Element mit einer steuerbaren Steifigkeit ($P_R$) in Kontakt mit dem Stapel ($E_T$) oder in Kontakt mit dem Balken oder der Membran (P) aufweist.

**15.** Transformator nach Anspruch 14, wobei das Element mit einer steuerbaren Steifigkeit eine fünfte piezoelektrische Schicht ($P_R$) aus einem sechsten Polymermaterial aufweist.


## Claims

**1.** A voltage transformer comprising a beam or membrane (P) made of a first polymer material having a resonance frequency in the range from 1 Hz to 1,000 Hz and comprising on said beam or membrane (P) a stack ($E_T$) successively comprising:

> a first electrode ($E_0$);
> a first piezoelectric layer ($C_1$) made of a second polymer material;
> a second electrode ($E_{ref}$);
> a second piezoelectric layer ($C_{out}$) made of a third polymer material identical to the second polymer material or different from the second polymer material; and
> a third electrode ($E_{out}$) .

**2.** The transformer of claim 1, wherein the first polymer material has a Young's modulus smaller than 10 GPa.

**3.** The transformer of claim 1 or 2, wherein the first polymer material is polyethylene naphthalate (PEN) or polyethylene terephthalate (PET).

**4.** The transformer of any of claims 1 to 3, wherein the second and third polymer materials comprise polyvinylidene fluoride and/or at least one copolymer of polyvinylidene fluoride, particularly a polymer selected from the group comprising polyvinylidene fluoride, poly(vinylidene fluoride - trifluoroethylene), poly(vinylidene fluoride - tetrafluoroethylene), and a mixture of at least two of these polymers.

**5.** The transformer of any of claims 1 to 4, further comprising a support (S) and wherein the beam or membrane (P) is fastened by one of its ends to the support (S).

**6.** The transformer of any of claims 1 to 5, wherein the second polymer material and the third polymer material are identical and the thickness of the first layer ($C_1$) is different from the thickness of the second layer ($C_{out}$).

**7.** The transformer of any of claims 1 to 6, wherein the beam or membrane (P) has a length in the range from 1 mm to 100 mm and a thickness in the range from 50 $\mu$m to 200 $\mu$m, and wherein the first and second layers ($C_1$, $C_{out}$) have a thickness in the range from 1 $\mu$m to 50 $\mu$m.

**8.** The transformer of any of claims 1 to 7, wherein the stack ($E_T$) further successively comprises, between the first piezoelectric layer ($C_1$) and the second electrode ($E_{ref}$), a fourth electrode ($E_1$) and a third piezoelectric layer ($C_2$) made of a fourth polymer material.

**9.** The transformer of claim 8, wherein the fourth polymer material comprises polyvinylidene fluoride and/or at least one copolymer of polyvinylidene fluoride, particularly a polymer selected from the group comprising polyvinylidene fluoride, poly(vinylidene fluoride - tri fluoro ethylene), poly(vinylidene fluoride - tetra fluoro ethylene), and a mixture of at least two of these polymers.

10. The transformer of claim 8 or 9, comprising means of application of a first voltage ($V_1$) between the fourth electrode ($E_1$) and the first electrode ($E_0$) and between the fourth electrode ($E_1$) and the second electrode ($E_{ref}$) and comprising means for recovering a second voltage ($V_2$) between the third electrode ($E_{out}$) and the second electrode ($E_{ref}$).

11. The transformer of claim 8 and 9, wherein the stack ($E_T$) further successively comprises, between the third layer ($C_2$) and the second electrode ($E_{ref}$), a fifth electrode ($E_2$) and a fourth piezoelectric layer ($C_3$) made of a fifth polymer material.

12. The transformer of claim 11, wherein the fifth polymer material comprises polyvinylidene fluoride and/or at least one copolymer of polyvinylidene fluoride, particularly a polymer selected from the group comprising polyvinylidene fluoride, poly(vinylidene fluoride - tri fluoro ethylene), poly(vinylidene fluoride - tetra fluoro ethylene), and a mixture of at least two of these polymers.

13. The transformer of claim 11 or 12, comprising means of application of a first voltage ($V_1$) between:

the first electrode ($E_0$) and the fourth electrode ($E_1$) ;
the fifth electrode ($E_2$) and the fourth electrode ($E_1$); and
the fifth electrode ($E_2$) and the second electrode ($E_{ref}$), and
comprising means for recovering a second voltage ($V_2$) between the third electrode ($E_{out}$) and the second electrode ($E_{ref}$).

14. The transformer of any of claims 1 to 13, further comprising an element having a controllable stiffness ($P_R$) in contact with the stack ($E_T$) or in contact with the beam or membrane (P) .

15. The transformer of claim 14, wherein the element having a controllable stiffness comprises a fifth piezoelectric layer ($P_R$) made of a sixth polymer material.

**Fig 1**

**Fig 2A**

**Fig 2B**

Fig 3A

Fig 3B

$E_2$

Fig 3C

EP 3 340 326 B1

$E_o$ $C_1$ $E_{ref}$ $C_{out}$ $E_{out}$

40

S

$V_2$
$V_1$

$V_{ctrl}$

P $E_{R1}$ $P_R$ $E_{R2}$

Fig 4

$E_{R2}$ $P_R$ $E_{R1}$ $C_{out}$ $E_{out}$ $C_{iso}$

50

S

$V_{ctrl}$

$V_2$
$V_1$

$E_0$ $C_1$ $E_{ref}$ P

Fig 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2006041150 A
- EP 0915524 A1

**Littérature non-brevet citée dans la description**

- **VUCHEVA Y D et al.** *Materials Science Forum,* 2016, vol. 856, 356-361